# EUROPÄISCHE PATENTSCHRIFT

(11) **EP 2 110 929 B1**
(45) Veröffentlichungstag und Bekanntmachung des Hinweises auf die Patenterteilung: **29.08.2018**
(21) Anmeldenummer: 08007602.9
(22) Anmeldetag: 18.04.2008
(51) Int. Cl.: H02K 17/30, H05K 7/20, H02K 11/33, H02K 5/18

(54) **Frequenzumrichter auf einem Motor**
Frequency inverter being mounted on a motor
Convertisseur de fréquence attachée sur un moteur

(43) Veröffentlichungstag der Anmeldung: 21.10.2009
(73) Patentinhaber: Grundfos Management a/s, 8850 Bjerringbro (DK)
(72) Erfinder: Mønster, Peter, 8900 Randers (DK); Petersen, Niels Høgholt, 8850 Bjerringbro (DK)
(74) Vertreter: Vollmann, Heiko

(56) Entgegenhaltungen:
- EP-A- 1 104 079
- DE-A1- 19 652 186
- DE-A1-102005 032 968
- US-A- 5 650 914

## Beschreibung

Die Erfindung betrifft einen Frequenzumrichter zur Montage auf einem Elektromotor.
Es zählt heutzutage zum Stand der Technik, einen Frequenzumrichter bzw. Frequenzumformer, wie er bei modernen Motoren zur Steuerung der Drehzahl, insbesondere zur Erzielung von Drehzahlen jenseits der durch die Netzfrequenz physikalisch bedingten Drehzahl eingesetzt wird, in einem Gehäuse anzuordnen, das zur Montage auf dem Elektromotor ausgebildet und bestimmt ist, so dass Frequenzumrichter und Motor fest miteinander verkabelt und zusammen gehandhabt und eingebaut werden können. Das Frequenzumrichtergehäuse ist dabei typischerweise nach Art eines vergrößerten Klemmenkastens gestaltet und ist mit einem gewissen Abstand am Außenumfang des Motors angeordnet. Um die insbesondere im Leistungskreis aber auch im übrigen Frequenzumrichter anfallende Wärme abzuführen, ist das Frequenzumrichtergehäuse, insbesondere der untere, mit dem Motor verbundene Gehäuseteil wärmeleitend, typischerweise aus Metall und berippt ausgebildet Aus DE 10 2005 032 968 A1 zählt es zum Stand der Technik, an der Unterseite des Frequenzumrichtergehäuses Kühlrippen anzuordnen, welche im Kühlluftstrom des Motors liegen, der durch ein auf einem Ende der Motorwelle sitzendes Lüfterrad und eine dieses umgebende stirnseitig des Motors angeordnete Lüfterhaube erzeugt wird und längs der Außenseite des Motors umfangsseitig strömt und somit auch die Unterseite des Frequenzumrichtergehäuses und die dort vorgesehenen Kühlrippen erfasst.

Dieses Kühlprinzip hat sich zwar bewährt doch ist es konstruktiv problematisch, einerseits eine möglichst kompakte Konstruktion des Frequenzumrichters vorzuschlagen, andererseits jedoch die Kühlung und Anordnung der Bauteile so zu wählen, das unterschiedliche Wärmezonen entstehen, die den thermischen Belastungscharakteristika der einzelnen Bauteile entsprechen. So können beispielsweise die elektronischen Schalter des Leistungskreises in der Regel höhere Betriebstemperaturen ertragen als die Kondensatoren des Zwischenkreises und die wiederum höhere als die Steuer- und Regelelektronik.

Aus EP 1 104 079 A2 zählt es zum Stand der Technik, das Frequenzumrichtergehäuse mit radial zur Motorachse angeordnetem, also Querrippen zu versehen.

Vor diesem Hintergrund liegt der Erfindung die Aufgabe zugrunde, einen Frequenzumrichter der eingangs genannten Art zu schaffen, der einerseits kompakt aufgebaut ist, d. h. den im Frequenzumrichtergehäuse umschlossenen Raum möglichst gut ausnutzt, der anderseits eine effektive Kühlung gewährleistet und dies den thermischen Anforderungen der jeweiligen Bauteile/Baugruppen entsprechend.

Diese Aufgabe wird gemäß der Erfindung durch die in Anspruch 1 angegebenen Merkmale gelöst. Vorteilhafte Ausgestaltungen der Erfindung sind in den Unteransprüchen der nachfolgenden Beschreibung und der Zeichnung angegeben.

Der erfindungsgemäße Frequenzumrichter weist ein Gehäuse auf, das zur umfangseitigen Montage auf einem Elektromotor ausgebildet und bestimmt ist und bei dem zumindest der Boden wärmeleitend ausgebildet ist. Der Boden des Frequenzumrichtergehäuses ist in einem mittleren Bereich an seiner Außenseite, und zwar an der zum Motor weisenden Außenseite außen mit Längsrippen versehen und innen mit wärmeerzeugenden Bauteilen des Leistungskreiss des Frequenzumrichters wörmeleitend verbunden. Darüber hinaus weist der Boden in mindestens einem neben dem mittleren Bereich angeordneten äußeren Bereich quer oder schräg zu den Längsrippen außen angeordnete Kühlrippen auf und ist in diesem Bereich innen wärmeleitend mit wärmeerzeugenden Bauteilen des Eingangs- und/oder Zwischenkreises des Frequenzumrichters kraftschlüssig verbunden.

Durch diese erfindungsgemäße Ausbildung wird eine besonders effektive und für die verwendeten Bauteile günstige Kühlung erreicht. Dabei bildet sich längs der Längsrippen, also dort wo das Gehäuse motornah angeordnet ist und durch den Kühlluftstrom des Motors gekühlt wird, eine Längsströmung zwischen Motor und der Unterseite des Gehäuses des Frequenzumrichters aus, die eine intensive Kühlung der in diesem Bereich innen wärmeleitend mit dem Boden verbundenen Bauteilen des Leistungskreiss gewährleistet. Dieser Kühlluftstrom wird durch das Lüfterrad des Motors erzeugt, auf dem der Frequenzumrichter angeordnet ist. Darüber hinaus bildet sich jedoch aufgrund der in einem äußeren Bereich quer oder schräg zu den Längsrippen angeordneten Kühlrippen ein Konvektionskühlstrom, der zwar eine geringere Strömungsgeschwindigkeit als der Längskühlluftstrom aufweisen wird, der jedoch bei geeigneter Konstruktion der Quer- bzw. Schrägrippen ausreicht, die gemäß der Erfindung in diesem Bereich an der Innenseite kraftschlüssig und wärmeleitend mit dem Gehäuse verbundenen wärmeerzeugenden Bauteile des Eingangskreises und/oder Zwischenkreises des Frequenzumrichters zu kühlen. Die Anordnung ist zudem so, dass sich in dem äußeren Bereich im Betrieb ein geringeres Temperaturniveau einstellt als im mittleren Bereich, wo die Leistungselektronik angeordnet ist. Es ist daher durch die erfindungsgemäße Konstruktion möglich, die elektronischen Bauteile des Leistungskreis in unmittelbarer Nähe der elektrischen/elektronischen Bauteile des Eingangskreises und/oder Zwischenkreises anzuordnen, ohne diese thermisch zu überlasten.

Vorteilhaft ist gemäß einer Weiterbildung der Erfindung die Außenkontur des Frenquenzumrichtergehäuses an der Unterseite entsprechend der Außenkontur des Elektromotors gekrümmt ausgebildet. Hierdurch kann ein ohnehin nicht nutzbarer Freiraum für den Frequenzumrichter genutzt werden. Ein weiterer Vorteil dieser gekrümmten Außenkontur des Frequenzumrichters an seiner Unterseite, d.h. seiner zum Motor gewandten Seite ist, dass neben dem mittleren Bereich, in dem die Leistungselektronik angeordnet ist, die äußeren daneben angeordneten Bereiche des Gehäusebodens tiefer liegen, was den Erhalt unterschiedlicher Wärmeniveaus innerhalb des Frequenzumrichters unterstützt, insbesondere verhindert, dass in diesen äußeren Bereichen des Frequenzumrichtergehäuses die im Leistungskreis herrschenden hohen Temperaturen entstehen. Zudem wird durch diese Gehäuseausbildung in den äußeren Bereichen Raum für großbauende Bauelemente wie beispielsweise Spulen und Kondensatoren geschaffen.

Um eine intensive Kühlung des Leistungskreiss im mittleren Bereich zu gewährleisten, ist es zweckmäßig, die sich zwischen benachbarten Längsrippen an der zum Motor gewandten Seite des Frequenzumrichtergehäuses erstreckenden und zum Motor offenen Kühlkanäle ununterbrochen auszubilden, sodass der Kühlluftstrom nach Möglichkeit über die gesamte Länge des Frequenzumrichters von einem bis zum anderen Ende in einer Längsströmung entlang strömen kann. Hierzu ist insbesondere die zwischen Frequenzumrichtergehäuse und Motorgehäuse erforderliche Kabeldurchführung, die regelmäßig eine Unterbrechung der Kühlkanäle bildet, in einem seitlichen oder äußeren Bereich zu verlegen. Dabei erstrecken sich die Längsrippen an der Unterseite des Frequenzumrichters vorzugsweise über die gesamte Länge, um dort eine gerichtete, vorzugsweise laminare Strömung zu führen, die eine gute Wärmeabfuhr in diesem Bereich gewährleistet.

Um einen effektiven Wärmeübergang von einem Wärme erzeugenden Bauteil innerhalb des Frequenzumrichtergehäuses zum Gehäuseboden und den dort außenseitig angeordneten Kühlrippen zu schaffen, sind innerhalb des Gehäuses bodenseitig Wärmeanschlussflächen vorgesehen, und zwar im mittleren Bereich für Wäre erzeugende Bauteile des Leistungskreiss, typischerweise die elektronischen Schalter, und in einem, vorzugsweise in beiden äußeren Bereichen Wärmeanschlussflächen für Wärme erzeugende Bauteile des Eingangskreises und/oder des Zwischenkreises. Solche Wärme erzeugenden Bauteile des Eingangs- und Zwischenkreises können Gleichrichter, Spulen, Kondensatoren oder dergleichen sein, sie sind kraftschlüssig und somit hoch wärmeleitend mit den Anschlussflächen verbunden.

Über diese Anschlussflächen wird ein gut Wärme leitender Kontakt zu den Wärme erzeugenden Bauteilen hergestellt. Dabei ist es gemäß einer Weiterbildung der Erfindung besonders vorteilhaft, wenn die Wärmeanschlussflächen im äußeren Bereich bzw. in den beiden äußeren Bereichen auf einem anderen, insbesondere tieferen Niveau als im mittleren Bereich angeordnet sind. Hierdurch wird einerseits eine gute räumliche Nutzung des Innenraums gewährleistet und zum anderen werden die vorbeschriebenen unterschiedlichen Temperaturniveaus innerhalb des Frequenzumrichtergehäuses unterstützt.

Die vorstehend verwendeten, die räumliche Zuordnung betreffenden Begriffe wie oben, unten, tief, hoch, längs und quer betreffen eine übliche Motoranordnung, bei welcher der Motor mit seiner Mittellängsachse bodenparallel angeordnet und der Frequenzumrichter auf der vom Boden abgewandten Seite des Motors an seiner Umfangsfläche angeordnet ist.

Gemäß der Erfindung werden in diesen äußeren Bereichen des Frequenzumrichtergehäuses, die vorteilhaft tiefer reichen als der mittlere Bereich, Kondensatoren und/oder Spulen des Zwischenkreises angeordnet und wärmeleitend mit dem Gehäuseboden verbunden. Dabei werden die Kondensatoren vorteilhaft stehend angeordnet, da auf diese Weise zum einen die Topographie des Gehäusebodens am besten ausgenutzt wird, zum anderen durch die stirnseitige Ankopplung eine gute Wärmeleitung entsteht.

Weiter vorteilhaft können in diesem äußeren Bereich des Gehäuses auch Wärme erzeugende Bauteile des Eingangskreises angeordnet werden, beispielsweise eine RFI-Spule, die ebenfalls vergleichsweise viel Einbauraum benötigt und somit in diesem Bereich in nahezu idealer Weise verbaut werden kann.

Bei der vorstehend beschriebenen Topographie des Frequenzumrichtergehäuses und der Anordnung der Bauteile können diese Wärme erzeugenden Bauteile vorteilhaft auf einer Platine angeordnet sein, welche mit Abstand zum Gehäuseboden derart angeordnet ist, dass die Wärme erzeugenden Bauteile jeweils eine zum Gehäuseboden weisende Wärmeanschlussfläche aufweisen und mittels eines Koppelkörpers kraftschlüssig und somit gut Wärme leitend mit der zugehörigen Wärmeanschlussfläche verbunden sind. Diese Anordnung hat somit den großen Vorteil, dass eine Vielzahl von Wärme erzeugenden Bauteilen elektrisch mittels einer Platine verdrahtet werden können, also Einzelverdrahtungen weitgehend entfallen, andererseits diese Bauteile über entsprechende Wärmeanschlussflächen wärmeleitend mit dem intensiv gekühlten Gehäuseboden verbunden sind. Die Bauteile werden also quasi hängend auf der Platine installiert und sind an ihrer Unterseite durch die Wärmeanschlussflächen kraftschlüssig abgestützt. Die Gewichtskraft wirkt somit unterstützend in Richtung auf die Wärmeanschlussflächen, was ebenfalls vorteilhaft ist.

Die vorbeschriebene erfindungsgemäße Ausbildung ermöglicht weiterhin in vorteilhafter Weise die Wärme erzeugenden Bauteile sowohl des Zwischenkreises als auch des Leistungskreises auf derselben Platine anzuordnen, was von ganz besonderem Vorteil ist, da zwischen Zwischenkreis und Leistungskreis keine Kabelverbindungen erforderlich sind, die, wenn sie als Lötverbindungen ausgestaltet sind, aufwendig und teuer und bei Wartungs- und Reparaturzwecken hinderlich und wenn sie als Steckverbindungen ausgebildet sind, aufgrund der im Betrieb im Gehäuse auftretenden Schwingungsbelastung anfällig gegen Schwingungsreibungsverschleiß (Fretting Corosion) sind.

Um Fertigungstoleranzen und wärmebedingte Abmessungsänderungen der Bauteile zu kompensieren, ohne die Platine mechanisch unzulässig zu belasten, andererseits jedoch eine gute Wärmeübertragung zwischen den Bauteilen und den Anschlussteilen zu gewährleisten, sind gemäß der Erfindung Koppelkörper vorgesehen, die vorteilhaft so ausgebildet sind, dass sie elektrisch isolierend, gut wärmeleitend und darüber hinaus elastisch sind, um die vorgenannten Abmessungsänderungen ausgleichen und die erforderliche Vorspannkraft aufbringen zu können.

Gemäß einer vorteilhaften Weiterbildung der Erfindung ist ein solcher Koppelkörper zweischichtig aufgebaut und weist eine erste formstabile und eine zweite formausgleichende elastische Schicht auf. Die elastische Schicht dient dabei zur Anpassung und kraftschlüssigen Kopplung mit dem Bauteil wohingegen die formstabile Schicht zum thermischen Ankoppeln an die Wärmeanschlussfläche vorgesehen und bestimmt ist.

Dabei ist es besonders vorteilhaft, wenn die formstabile Schicht eine Gitterstruktur aufweist. Schichtdicken dieser Schicht zwischen 0,7 und 1,3 mm haben sich als vorteilhaft bewährt. Die elastische Schicht hingegen ist so zu dimensionieren, dass einerseits der vorbeschriebene Toleranz- oder wärmebedingt Abmessungsausgleich erfolgen kann, andererseits die Schicht so dünn wie möglich ist, um einen guten Wärmeübergang zu gewährleisten. Vorteilhaft weist somit die elastische Schicht gemäß der Erfindung eine 2,5 bis 3,5-fache Dicke der formstabilen Schicht auf, vorzugsweise eine Dicke zwischen 5 und 6 mm. Darüber hinaus ist die elastische Schicht vorteilhaft elektrisch isolierend, sodass die ohnehin vergleichsweise dünne formstabile Schicht ggf. auch elektrisch leitend ausgebildet sein kann.

Die Anordnung der elektronischen/elektrischen Bauteile innerhalb des Frequenzumrichters ist gemäß einer vorteilhaften Weiterbildung der Erfindung so gewählt, dass die Stromführung innerhalb des Gehäuses, insbesondere im Bereich der bodennahen Platine oder Platinen im Wesentlichen kreisförmig ist, d.h. dass die Stromführung von dem Netzanschluss zum Motor hin kreisförmig zunächst in den Eingangskreis, dann in den Zwischenkreis und schließlich in den Leistungskreis und von da zur Durchführung zum Motor hin erfolgt.

Die Erfindung ist nachfolgend anhand eines in der Zeichnung dargestellten Ausführungsbeispiels näher erläutert. Es zeigen:
- Fig. 1: in perspektivischer Explosionsdarstellung einen Elektromotor mit Frequenzumrichter,
- Fig. 2: den grundsätzlichen elektrischen Aufbau eines Frequenzumrichters in Form eines stark vereinfachten Schaltbildes,
- Fig. 3: in perspektivischer Darstellung den unteren Teil eines Frequenzumrichtergehäuses von schräg oben,
- Fig. 4: das untere Frequenzumrichtergehäuseteil gemäß Fig. 3 von der Unterseite,
- Fig. 5: in perspektivischer Darstellung das untere Frequenzumrichtergehäuseteil in einer Vormontagestellung,
- Fig. 6: in Darstellung nach Fig. 5 im montierten Zustand,
- Fig. 7: eine stark vereinfachte perspektivische Ansicht auf ein Platine, welche die Bauteile des Zwischen- und Leistungskreises trägt und
- Fig. 8: eine perspektivische Ansicht auf eine Platine, welche Bauteile des Eingangskreises trägt.

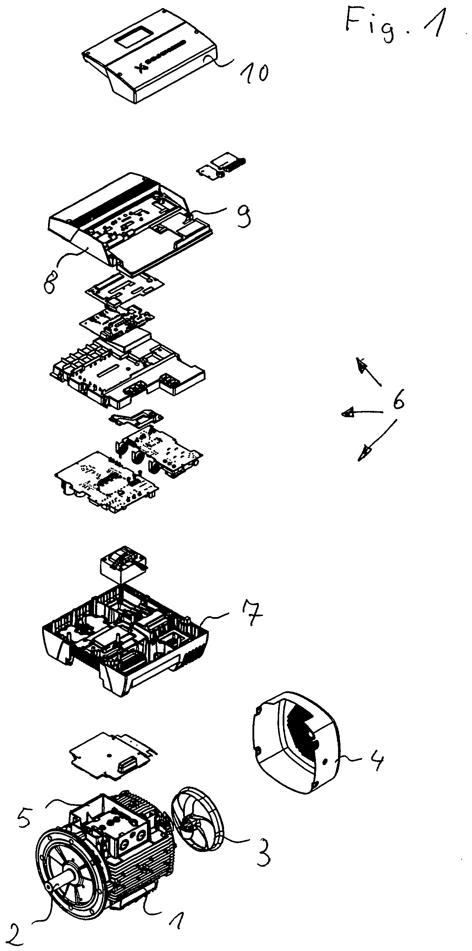

Die Explosionsdarstellung gemäß Fig. 1 zeigt den Gesamtaufbau des Aggregats mit einem Elektromotor 1 mir einer Antriebswelle 2, deren rückseitiges Ende ein Lüfterrad 3 trägt, welches von einer Lüfterhaube 4 abgedeckt wird, um so im Betrieb einen Luftstrom längs der mit Kühlrippen versehenen Umfangsfläche des Motors 1 parallel zur Längsachse zu erzeugen. Die Oberseite des Elektromotors ist mit einem kastenartigen Rahmen 5 versehen, der zur Befestigung eines Frequenzumrichters 6 vorgesehen ist, der einen unteren Gehäuseteil 7 aufweist, der am Rahmen 5 befestigt ist und dessen oberer Gehäuseteil durch einen Deckel 8 gebildet ist, der wiederum eine obere Öffnung 9 aufweist, die mittels einer Abdeckkappe 10 verschließbar ist. Diese Öffnung 9 gibt Zugang zu einer Art Klemmenkasten. Durch sie sind die elektrischen Anschlüsse des Netzkabels und die des Frequenzumrichters zugänglich, wenn die Abdeckkappe 10 entfernt ist.

Das im Wesentlich aus dem unteren Gehäuseteil 7 und dem oberen Gehäuseteil 8 bestehende Frequenzumrichtergehäuse ist als Gussteil ausgebildet und besteht aus einem gut Wärme leitenden metallischen Werkstoff, hier einer Leichtmetalllegierung. Der untere Gehäuseteil 7 ist auf dem ebenfalls aus Metall bestehenden Gehäuse des Elektromotors 1, und zwar dem Rahmen 5 befestigt, und zwar so, dass zwischen der Oberseite des Rahmens 5, die durch eine Platte abgedeckt ist, unter der Unterseite des unteren Gehäuseteils 7 ein Freiraum verbleibt, der von einem Teilluftstrom durchströmt wird, welcher vom Lüfterrad 3 erzeugt und längs der Außenseite des Motors strömt.

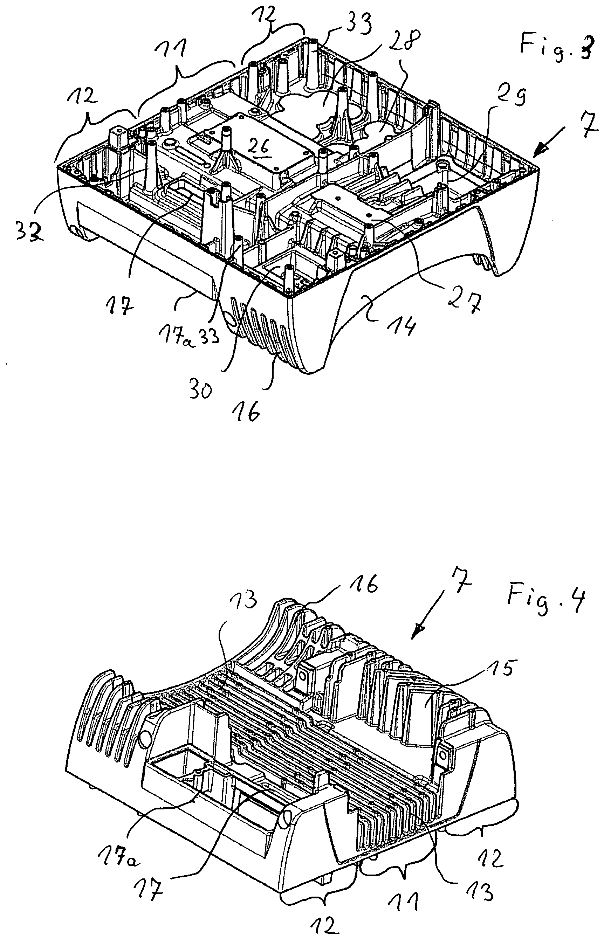

Wie insbesondere aus den Fig. 3 und 4 ersichtlich ist, ist das untere Gehäuseteil 7 an die im Wesentlichen kreisrunde Außenkontur des Elektromotors 1 angepasst. Das Gehäuseteil 7 weist einen mittleren Bereich 11 auf, der an seiner Unterseite, d.h. an der im montierten Zustand zum Motor weisenden Seite mit Längsrippen 11 versehen ist, die sich über die gesamte Länge des Gehäuseteils 7 durchgehend erstreckend und zwischen denen nach unten offene durchgehende Kühlkanäle für den vom Lüfterrad 3 längs des Motors 1 erzeugten Teilluftstrom gebildet sind, der diesen Bereich durchströmt. Die Längsrippen 13 sind an ihrem abströmseitigen Ende durch eine Querwand 14 begrenzt, die zugleich die das Frequenzumrichtergehäuse in Strömungsrichtung nach hinten abschließende Wand bildet.

Benachbart zu dem mittleren Bereich 11 sind zwei äußere Bereiche 12, in denen der untere Gehäuseteil 7, der Außenkontur des Motors 2 folgend in Einbaulage (Fig. 1) seitlich weiter heruntergezogen ist. In diesem Bereich 12 sind ebenfalls Kühlrippen angeordnet, die jedoch wie die Kühlrippen 15 schräg bzw. wie die Kühlrippen 16 quer zu den Längsrippen 13 und seitlich davon angeordnet sind. Weiterhin weist der untere Gehäuseteil 7 im äußeren Bereich eine Längsausnehmung 17, parallel zu den Längsrippen 13 und unmittelbar daran angrenzend auf, die zur Durchführung der elektrischen Leitungen zwischen Motor und Frequenzumrichter vorgesehen ist. Unmittelbar dazu nach außen benachbart ist im äußeren Bereich 12 eine weitere Ausnehmung 17a vorgesehen, die zum Eingliedern der Durchführung der elektrischen Anschlusskabel für den Netzanschluss vorgesehen ist.

Die insbesondere aus Fig. 4 ersichtliche Formgebung und Berippung des unteren Gehäuseteils 7 führt dazu, dass bei Anströmung des durch das Lüfterrad 4 erzeugten Kühlluftstroms sich im mittleren Bereich 11 ein im Wesentlichen in Längsrichtung unter dem Gehäuseteil 7 durchströmender Teilluftstrom bildet, der den mittleren Bereich vergleichsweise intensiv kühlt. In den äußeren Bereichen 12 bildet sich hingegen eine in Wesentlichen quer dazu gerichtete Konvektionströmung, welche den äußeren Bereich 12 kühlt, diese Strömung hat eine geringere Geschwindigkeit und somit auch eine geringere Kühlwirkung.

Entsprechend dieser unterschiedlichen Kühlwirkung im mittleren und im äußeren Bereich 11, 12 sind auch die Wärme erzeugenden Bauteile innerhalb des Gehäuseteils 7 angeordnet.

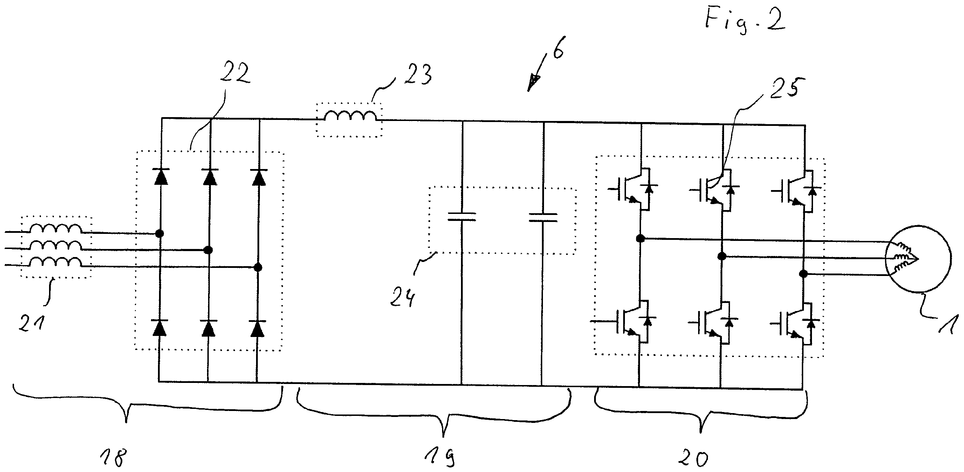

Die Wärme erzeugenden Bauteile des Frequenzumrichters sind aus dem Schaltbild gemäß Fig. 2 ersichtlich. Der Frequenzumrichter 6 weist einen Eingangskreis 18, einen Zwischenkreis 19 und einen Leistungskreis 20 auf. Im Eingangskreis ist zunächst ein RFI-Filter (Hochfrequenzfilter) in Form einer RFI-Spule 21 vorgesehen. Der Eingangskreis 18 weist weiterhin einen Gleichrichter 22 auf, der daran anschließende Zwischenkreis 19 ist in Fig. 2 durch eine Induktivität 23 und eine Kapazität 24 dargestellt, der Leistungskreis 20 durch elektronische Leistungsschalter und Freilaufdioden. Es versteht sich, dass neben den in Fig. 2 symbolhaft dargestellten elektronischen Bauteilen eine Vielzahl weiterer Bauteile vorhanden ist, wie dies beim Aufbau derartiger Frequenzumrichter üblich ist. Auch ist der notwendigerweise zur Ansteuerung erforderliche Steuer- und Regelkreis hier nicht im Einzelnen dargestellt.

Da innerhalb des Leistungskreises 20 die meiste Abwärme entsteht, ist dieser am intensivsten zu kühlen. Es ist daher an der Innenseite des unteren Gehäuseteils 7, dort wo die intensivste Kühlung erfolgt, also in Anströmrichtung gesehen im vorderen mittleren Bereich 11 eine Wärmeanschlussfläche 26 vorgesehen, über welche die Leistungsschalter 25 des Leistungskreises 20 ihre Wärme abgeben.

Weiterhin im mittleren Bereich 11, jedoch in Strömungsrichtung gesehen dahinter liegend ist eine Wärmeanschlussfläche 27 vorgesehen, welche zur Abfuhr der im Gleichrichter 22 anfallende Wärme vorgesehen ist.

In den äußeren Bereichen 12 sind Wärmeanschlussflächen 28 vorgesehen, für die Kapazität 24 des Zwischenkreises 19 also zum Anschluss der Kondensatoren. Weiterhin ist eine Wärmeanschlussfläche 29 für die Zwischenkreisinduktivität 23, also für eine Spule 23a vorgesehen. In dem äußeren Bereich 12 auf der anderen Seite ist eine Wärmeanschlussfläche 30 für die RFI-Spule 21 vorgesehen.

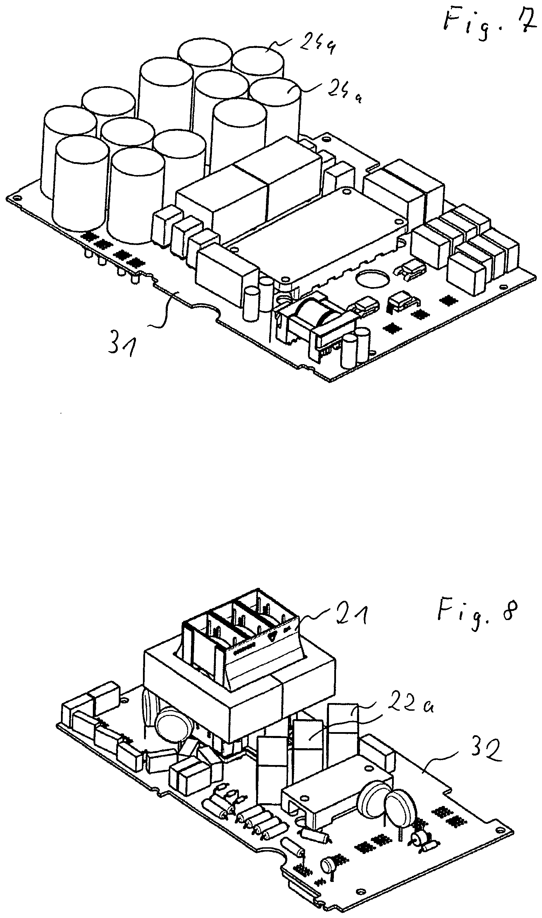

Die vorgenannten Bauteile sind, mit Ausnahme der Spule 23 des Zwischenkreises 19 auf zwei Platinen 31 und 32 angeordnet. Die Platine 31 umfasst die im mittleren Bereich angeordneten Wärme erzeugenden Bauteile 25 des Leistungskreises 20 sowie weitere Bauteile des Leistungskreises 20. Im äußeren Bereich sind Bauteile des Zwischenkreises 19 angeordnet, deutlich sichtbar sind die die Kapazität 24 bildenden Kondensatoren 24 a. Aufbau und Bestückung der Platinen ist im Einzelnen den Fig. 7 und 8 zu entnehmen. Die Platine 32 trägt die den Gleichrichter 22 bildenden Bauteile, insbesondere die Dioden 22 a sowie die RFI-Spule 21.

Die Platinen 31 und 32 sind im Wesentlichen in einer, die Teilungsebene des Frequenzumrichters bildenden Gehäuseebene angeordnet, und zwar so, dass die vorbeschriebene elektronischen Bauteile nach unten hängend, also in Richtung auf den Boden des Gehäuseteils 7 weisend angeordnet sind. Hierzu sind innerhalb des unteren Gehäusebauteils Stützen 33 vorgesehen, auf denen die Platinen 31, 32 aufliegen und in denen diese mittels Schrauben fest mit dem Gehäuse 7 verbunden sind. Die Wärme erzeugenden Bauteile sind dabei über jeweils einen einleitend beschriebenen, in den Zeichnungen nicht dargestellten Koppelkörper mit den zugehörigen Wärmeanschlussflächen 26 bis 30 des Gehäuseteils 7 kraftschlüssig verbunden. Diese Koppelkörper sind plattenförmig und weisen eine im Wesentlichen formstabile dünne Schicht auf, mit der sie an der Wärmeanschlussfläche anliegen sowie eine elastische und ebenfalls wärmeleitende jedoch elektrisch isolierende dickere Schicht auf, welche zum Ausgleich von Fertigungstoleranzen und Wärmedehnungen vorgesehen ist und die den Freiraum zwischen den nach unten gerichteten Wärmeanschlussflächen der elektrischen/elektronischen Bauteile und den Wärmeanschlussflächen 26 bis 30 ausfüllt. Diese elastische Schicht ist in montiertem Zustand vorgespannt und bildet somit den Kraftschluss zwischen Wärmeanschlussfläche und Bauteil zur Wärmeleitung.

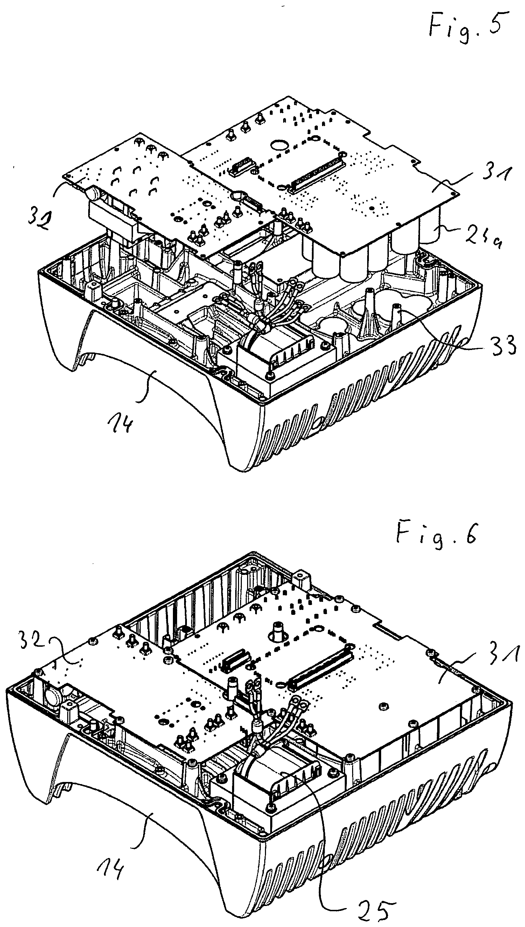

Wie insbesondere die Fig. 3 und 5 verdeutlichen, sind die Wärmeanschlussflächen 26 und 27 im intensiv gekühlten mittleren Bereich 11 auf einem höheren Niveau angeordnet als die Wärmeanschlussflächen 28 bis 30 in den äußeren Bereichen. Hierdurch wird zum einen den Baugrößen der jeweiligen Bauteile Rechnung getragen, zum anderen den thermischen Charakteristika dieser Bauteile. So sind die äußeren Bereiche 12 und die darin angeordneten Bauteile thermisch weniger belastet als die im mittleren Bereich 11 angeordneten Bauteile, wo jedoch eine höhere Wärmeabfuhr durch den intensiveren Kühlluftstrom erfolgt. Thermisch am geringsten belastet sind die lediglich in Fig. 1 sichtbaren über den Platinen 31 und 32 angeordneten Platinen und Bauteile, welche beispielsweise den Steuer- und Regelkreis umfassen.

Wie anhand der Fig. 3 und 5 erkennbar ist, erfolgt die Stromführung innerhalb des Frequenzumrichters 6 im Wesentlichen kreisförmig. Von den elektrischen Netzanschlüssen fließt der Strom zunächst in die RFI-Spule 21, die auf der Platine 32 sitzt und zum Anschluss an die Wärmeanschlussfläche 30 im äußeren Bereich 12 (Fig. 3 vorne) vorgesehen ist. Von dort in den Gleichrichter 22, der ebenfalls auf der Platine 32 sitzt und dessen Wärme über die Wärmeanschlussfläche 27 abgeführt wird. Von dort ist die Stromführung zum Zwischenkreis 19, die entsprechenden Wärmeanschlussflächen 29 für die Spule 23a und 28 für die Kondensatoren 24a sind im äußeren Bereich 12 (Fig. 4 rechts vorne und hinten) angeordnet. Von dort ist die Stromführung zum Leistungskreis 20 gerichtet, die entsprechenden Bauteile 25 werden über die Wärmeanschlussfläche 26 im mittleren Bereich gekühlt, von wo aus über die Ausnehmung 17 die Bestromung zum Stator des Elektromotors 1 hin erfolgt.

### Bezugszeichenliste

- 1: - Elektromotor
- 2: - Antriebswelle
- 3: - Lüfterrad
- 4: - Lüfterhaube
- 5: - Rahmen
- 6: - Frequenzumrichter
- 7: - unterer Gehäuseteil
- 8: - Deckel
- 9: - Öffnung für 10
- 10: - Abdeckkappe für 9
- 11: - mittlerer Bereich
- 12: - äußerer Bereich
- 13: - Längsrippen
- 14: - Querwand
- 15: - Kühlrippen schräg
- 16: - Kühlrippen quer
- 17: - Längsausnehmung
- 17a: - Ausnehmung für Netzanschluss
- 18: - Eingangskreis
- 19: - Zwischenkreis
- 20: - Leistungskreis
- 21: - RFI-Spule
- 22: - Gleichrichter
- 22a: - Gleichrichterdioden
- 23: - Induktivität
- 23a: - Spule
- 24: - Kapazität
- 24a: - Kondensatoren
- 25: - Leistungsschalter
- 26: - Wärmeanschlussfläche für 25
- 27: - Wärmeanschlussfläche 22a
- 28: - Wärmeanschlussfläche für 24a
- 29: - Wärmeanschlussfläche für 23a
- 30: - Wärmeanschlussfläche für 21
- 31: - Platine für Zwischen- und Leistungskreis
- 32: - Platine für Eingangskreis
- 33: - Stützen

## Patentansprüche

1. Frequenzumrichter mit einem Gehäuse (7, 8), das zur umfangseitigen Montage auf einem Elektromotor (1) ausgebildet und bestimmt ist und dessen Boden wärmeleitend ausgebildet und in einem mittleren Bereich (11) außen mit Längsrippen (13) versehen und innen mit wärmeerzeugenden Bauteilen (25) des Leistungskreises (20) des Frequenzumrichters wärmeleitend verbunden ist, **dadurch gekennzeichnet, dass** der Boden in mindestens einem äußeren Bereich (12) quer oder schräg zu den Längsrippen (13) außen angeordnete Kühlrippen (15, 16) und innen wärmeleitend damit kraftschlüssig verbundene wärmeerzeugende Bauteile (21, 23, 24) des Eingangskreises (18) und/oder Zwischenkreises (19) des Frequenzumrichters (6) aufweist.

2. Frequenzumrichter nach Anspruch 1, **dadurch gekennzeichnet, dass** die Außenkontur des Gehäuses (7, 8) an der Unterseite entsprechend der Außenkontur des Elektromotors (1) gekrümmt ausgebildet ist.

3. Frequenzumrichter nach einem der vorhergehenden Ansprüche, **dadurch gekennzeichnet, dass** zwischen benachbarten Längsrippen (13) an der zum Motor (1) weisenden Seite des Gehäuses (7, 8) sich in Längsrichtung erstreckende ununterbrochene und zum Motor (1) hin offene Kühlluftkanäle gebildet sind, wobei sich die Längsrippen (13) vorzugsweise über die gesamte Länge des Gehäuses (7, 8) erstrecken.

4. Frequenzumrichter nach einem der vorhergehenden Ansprüche, **dadurch gekennzeichnet, dass** der Boden im mittleren Bereich (11) mindestens eine Wärmeanschlussfläche (26) für wärmeerzeugende Bauteile (25) des Leistungskreises (20) und in einem äußeren Bereich (12) mindestens eine Wärmeanschlussfläche (28-30) für wärmeerzeugende Bauteile (21, 23a, 24a) des Eingangskreises (18) und/oder Zwischenkreises (19) aufweist und dass die Wärmeanschlussflächen (28-30) im äußeren Bereich (12) auf anderem, insbesondere tieferen Niveau als im mittleren Bereich (11) angeordnet sind.

5. Frequenzumrichter nach einem der vorhergehenden Ansprüche, **dadurch gekennzeichnet, dass** im äußeren Bereich (12) des Gehäuses (7, 8) ein oder mehrere Kondensatoren (24a) und/oder Spulen (23a) des Zwischenkreises (20) angeordnet und wärmeleitend mit dem Gehäuseboden verbunden sind.

6. Frequenzumrichter nach einem der vorhergehenden Ansprüche, **dadurch gekennzeichnet, dass** im äußeren Bereich (12) des Gehäuses (7, 8) eine RFI-Spule (21) des Eingangskreises (18) angeordnet und wärmeleitend mit dem Gehäuseboden verbunden sind.

7. Frequenzumrichter nach einem der vorhergehenden Ansprüche, **dadurch gekennzeichnet, dass** wärmeerzeugende Bauteile auf einer Platine (31, 32) angeordnet sind, welche mit Abstand zum Gehäuseboden derart angeordnet ist, dass die Bauteile (21, 22a, 24a, 25) jeweils eine zum Gehäuseboden weisende Wärmeanschlußfläche aufweisen und mittels eines Koppelkörpers wärmeleitend mit der zugehörigen Wärmeanschlussfläche (26, 27, 28, 29, 30) verbunden sind.

8. Frequenzumrichter nach einem der vorhergehenden Ansprüche, **dadurch gekennzeichnet, dass** die wärmeerzeugenden Bauteile (24a, 25) des Zwischenkreises (19) und des Leistungskreises (20) auf derselben Platine (31) angeordnet sind.

9. Frequenzumrichter nach einem der vorhergehenden Ansprüche, **dadurch gekennzeichnet, dass** die Koppelkörper elektrisch isolierend, wärmeleitend und elastisch ausgebildet sind.

10. Frequenzumrichter nach einem der vorhergehenden Ansprüche, **dadurch gekennzeichnet, dass** die Koppelkörper zweischichtig aufgebaut sind und eine erste formstabile und eine zweite formausgleichende elastische Schicht aufweisen.

11. Frequenzumrichter nach einem der vorhergehenden Ansprüche, **dadurch gekennzeichnet, dass** die formstabile Schicht eine Gitterstruktur aufweist und vorzugsweise eine Dicke von 0,7 bis 1,3 mm aufweist.

12. Frequenzumrichter nach einem der vorhergehenden Ansprüche, **dadurch gekennzeichnet, dass** die elastische Schicht elektrisch isolierend ist und eine 2,5 bis 3,5-fache Dicke der formstabilen Schicht aufweist, vorzugsweise eine Dicke zwischen 5 und 6mm aufweist.

13. Frequenzumrichter nach einem der vorhergehenden Ansprüche, **dadurch gekennzeichnet, dass** die Anordnung der elektronischen Bauteile (21, 22a, 23a, 24a, 25) von Eingangskreis, Zwischenkreis und Leistungskreis (18, 19, 20) derart ist, dass die Stromführung im Gehäuse (7, 8) im Wesentlichen kreisförmig ist.

## Claims

1. A frequency converter with a housing (7, 8) which is designed and envisaged for the peripheral assembly on an electric motor (1) and whose base is designed in a thermally conductive manner and in a middle region (11) is provided at the outside with longitudinal ribs (13) and at the inside is thermally conductively connected to heat-producing components (25) of the power circuit (20) of the frequency converter, **characterised in that** the base in at least one outer region (12) comprises cooling ribs (15, 16) which are arranged at the outside transversely or obliquely to the longitudinal ribs (13) and at the inside comprises heat-producing components (21, 23, 24) of the input circuit (18) and/or of the intermediate circuit (19) of the frequency converter (6), said components being connected non-positively and thermally conductively to said base.

2. A frequency converter according to claim 1, **characterised in that** the outer contour of the housing (7, 8) is designed on the lower side in a curved manner corresponding to the outer contour of the electric motor (1).

3. A frequency converter according to one of the preceding claims, **characterised in that** uninterrupted cooling air channels which are open towards the motor (1) and extend in the longitudinal direction are formed on the side of the housing (7, 8) which faces the motor (1), between adjacent longitudinal ribs (13), wherein the longitudinal ribs (13) preferably extend over the whole length of the housing (7, 8).

4. A frequency converter according to one of the preceding claims, **characterised in that** the base in the middle region (11) comprises at least one heat connection surface (26) for heat-producing components (25) of the power circuit (20), and in an outer region (12) comprises at least one heat connection surface (28-30) for heat-producing components (21, 23a, 24a) of the input circuit (18) and/or intermediate circuit (19), and that the heat connection surfaces (28-30) in the outer region (12) are arranged at a different, in particular a deeper level than in the middle region (11).

5. A frequency converter according to one of the preceding claims, **characterised in that** one or more capacitors (24a) and/or coils (23a) of the intermediate circuit (20) are arranged and connected to the housing base in a heat-conducting manner, in the outer region (12) of the housing (7, 8).

6. A frequency converter according to one of the preceding claims, **characterised in that** an RFI-coil (21) of the input circuit (18) is arranged and connected to the housing base in a heat-conducting manner, in the outer region (12) of the housing (7, 8).

7. A frequency converter according to one of the preceding claims, **characterised in that** heat-producing components are arranged on a circuit board (31, 32) which is arranged at a distance to the housing base in a manner such that the components (21, 22a, 24a, 25) in each case comprise a heat connection surface which faces the housing base and are connected in a heat-conducting manner to the associated heat connection surface (26, 27, 28, 29, 30) by way of a coupling body.

8. A frequency converter according to one of the preceding claims, **characterised in that** the heat-producing components (24a, 25) of the intermediate circuit (19) and of the power circuit (20) are arranged on the same circuit board (31).

9. A frequency converter according to one of the preceding claims, **characterised in that** the coupling bodies are designed in an electrically insulating, heat-conducting and elastic manner.

10. A frequency converter according to one of the preceding claims, **characterised in that** the coupling bodies are constructed in a two-layered manner, and comprise a first shape-stable layer and a second shape-compensating elastic layer.

11. A frequency converter according to one of the preceding claims, **characterised in that** the shape-stable layer has a grid structure and preferably a thickness of 0.7 to 1.3 mm.

12. A frequency converter according to one of the preceding claims, **characterised in that** the elastic layer is electrically insulating and has 2.5 times to 3.5 times the thickness of the shape-stable layer, preferably a thickness between 5 and 6 mm.

13. A frequency converter according to one of the preceding claims, **characterised in that** the arrangement of the electronic components (21, 22a, 23a, 24a, 25) of the input circuit, intermediate circuit and power circuit (18, 19, 20) is such that the leading of current in the housing (7, 8) is essentially circular.

## Revendications

1. Convertisseur de fréquence comprenant un boîtier (7, 8) conçu et réalisé pour être monté de manière périphérique sur un moteur électrique (1) et dont le fond est thermo-conducteur et est pourvu à l'extérieur de nervures longitudinales (13) dans une zone médiane, et relié à l'intérieur de manière thermo-conductrice à des composants (25) du circuit de puissance (20) du convertisseur de fréquence générant de la chaleur,
**caractérisé en ce que** le fond présente, dans au moins une zone extérieure (12), des ailettes de refroidissement (15, 16) disposées à l'extérieur transversalement ou de manière oblique par rapport aux nervures longitudinales (13), et à l'intérieur des composants (21, 23, 24) du circuit d'entrée (18) et/ou du circuit intermédiaire (19) du convertisseur de fréquence (6) générant de la chaleur et reliés de manière thermo-conductrice, donc par liaison de force.

2. Convertisseur de fréquence selon la revendication 1, **caractérisé en ce que** le contour extérieur du boîtier (7, 8), au niveau de la face inférieure, est réalisé de manière courbe pour correspondre au contour extérieur du moteur électrique (1).

3. Convertisseur de fréquence selon l'une des revendications précédentes, **caractérisé en ce que** sont formés, entre des nervures longitudinales (13) adjacentes sur la face du boîtier (7, 8) orientée vers le moteur (1), des canaux d'air de refroidissement ininterrompus et ouverts en direction du moteur (1), qui s'étendent dans la direction longitudinale, les nervures longitudinales (13) s'étendant, de préférence, sur toute la longueur du boîtier (7, 8).

4. Convertisseur de fréquence selon l'une des revendications précédentes, **caractérisé en ce que** le fond présente, dans la zone médiane (11), au moins une surface de raccordement thermique (26) pour des composants (25) du circuit de puissance (20) générant de la chaleur, et dans une zone extérieure (12) au moins une surface de raccordement thermique (28-30) pour des composants (21, 23a, 24a) du circuit d'entrée (18) et/ou du circuit intermédiaire (19) générant de la chaleur, et **en ce que** les surfaces de raccordement thermique (28-30) sont disposées dans la zone extérieure (12) à un autre niveau, en particulier plus profond, que dans la zone médiane (11).

5. Convertisseur de fréquence selon l'une des revendications précédentes, **caractérisé en ce qu'**un ou plusieurs condensateurs (24a) et/ou bobines (23a) du circuit intermédiaire (20) sont disposés dans la zone extérieure (12) du boîtier (7, 8) et sont reliés au fond du boîtier de manière thermo-conductrice.

6. Convertisseur de fréquence selon l'une des revendications précédentes, **caractérisé en ce qu'**une bobine RFI (21) du circuit d'entrée (18) est disposée dans la zone extérieure (12) du boîtier (7, 8) et est reliée au fond du boîtier de manière thermo-conductrice.

7. Convertisseur de fréquence selon l'une des revendications précédentes, **caractérisé en ce que** des composants générant de la chaleur sont disposés sur une platine (31, 32) qui est agencée à distance du fond du boîtier de telle sorte que les composants (21, 22a, 24a, 25) présentent respectivement une surface de raccordement thermique orientée vers le fond du boîtier et sont reliés de manière thermo-conductrice à la surface de raccordement thermique (26, 27, 28, 29, 30) correspondante au moyen d'un élément de couplage.

8. Convertisseur de fréquence selon l'une des revendications précédentes, **caractérisé en ce que** les composants (24a, 25) du circuit intermédiaire (19) et du circuit de puissance (20) générant de la chaleur sont disposés sur la même platine (31).

9. Convertisseur de fréquence selon l'une des revendications précédentes, **caractérisé en ce que** les éléments de couplage sont électriquement isolants, thermo-conducteurs et exécutés pour être élastiques.

10. Convertisseur de fréquence selon l'une des revendications précédentes, **caractérisé en ce que** les éléments de couplage sont constitués de deux couches et comportent une première couche de forme stable et une seconde couche élastique à compensation de forme.

11. Convertisseur de fréquence selon l'une des revendications précédentes, **caractérisé en ce que** la couche de forme stable présente une structure en treillis et de préférence une épaisseur de 0,7 à 1,3 mm.

12. Convertisseur de fréquence selon l'une des revendications précédentes, **caractérisé en ce que** la couche élastique est électriquement isolante et a une épaisseur représentant 2,5 à 3,5 fois l'épaisseur de la couche de forme stable, de préférence une épaisseur comprise entre 5 et 6 mm.

13. Convertisseur de fréquence selon l'une des revendications précédentes, **caractérisé en ce que** l'agencement des composants électroniques (21, 22a, 23a, 24a, 25) du circuit d'entrée, du circuit intermédiaire et du circuit de puissance (18, 19, 20) est tel que la conduction de courant dans le boîtier (7, 8) est sensiblement circulaire.
